# EUROPEAN PATENT APPLICATION

(11) **EP 4 845 370 A1**
(43) Date of publication of application: **25.11.2026**
(21) Application number: 26175074.9
(22) Date of filing: 28.04.2026
(51) Int. Cl.: H10K 85/50, H10K 30/40

(54) **PHOTOELECTRIC CONVERSION DEVICE AND METHOD FOR MANUFACTURING PHOTOELECTRIC CONVERSION DEVICE**

(30) Priority: 23.05.2025 JP 2025086605; 25.11.2025 JP 2025202574
(71) Applicant: National University Corporation Kanazawa University, Ishikawa 920-1192 (JP); Toyota Jidosha Kabushiki Kaisha, Toyota-shi, Aichi-ken 471-8571 (JP)
(72) Inventor: SHAHIDUZZAMAN, Md., Kanazawa-shi, Ishikawa 920-1192 (JP); TAIMA, Tetsuya, Kanazawa-shi, Ishikawa 920-1192 (JP); NAKANO, Masahiro, Kanazawa-shi, Ishikawa 920-1192 (JP); YAMADA, Hidetaka, Kanazawa-shi, Ishikawa 920-1192 (JP); PALASSERY, Jaseela Ithikkal, Kanazawa-shi, Ishikawa 920-1192 (JP); WATARI, Tetsushi, Toyota-shi 471-8571 (JP); KOGURE, Tomonari, Toyota-shi 471-8571 (JP)
(74) Representative: Kuhnen & Wacker Patent- und Rechtsanwaltsbüro PartG mbB

(57) **Abstract**

A photoelectric conversion device and a method for manufacturing a photoelectric conversion device capable of improving durability are provided. A photoelectric conversion device according to the present disclosure includes first and second electrode layers (12, 16) and a photoactive layer (14) that is positioned between the first electrode layer (12) and the second electrode layer (16). The photoactive layer (14) contains a perovskite compound as a main component and contains a compound represented by Formula (1) in the specification as an additive. As a result of thorough study, the inventors of the present application have found that durability can be improved by adding the compound represented by Formula (1) to the photoactive layer (14) as an additive.

## Description

### BACKGROUND

The present disclosure relates to a photoelectric conversion device and a method for manufacturing a photoelectric conversion device.

Patent Literature 1 discloses a method for manufacturing a perovskite film. In a method for manufacturing a perovskite solar cell disclosed in Patent Literature 1, ionic liquid is added to a solution in which precursor substances for generating perovskite crystals are dissolved. Then a perovskite film is generated using this solution.

Patent Literature 1: Japanese Unexamined Patent Application Publication No. 2016-222492

### SUMMARY

There is a room for improving the performance of the aforementioned perovskite solar cell that uses the ionic liquid as an additive. In particular, there is a room for improving durability of the perovskite solar cell.

The present disclosure has been made in order to solve the aforementioned problem, and an object of the present disclosure is to provide a photoelectric conversion device and a method for manufacturing a photoelectric conversion device capable of improving durability.

A photoelectric conversion device according to the present disclosure includes first and second electrode layers and a photoactive layer that is positioned between the first electrode layer and the second electrode layer. The photoactive layer contains a perovskite compound as a main component and contains a compound represented by the following Formula (1) as an additive: 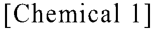 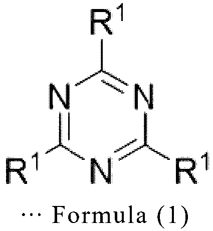 where
R¹ is a monovalent organic group or halogen having carbon atoms of 6 or less, and
a plurality of R¹ may be different from each other.

As a result of thorough study, the inventors of the present application have found that absorbance can be improved by adding the compound represented by the above Formula (1) to the photoactive layer as an additive.

In the photoelectric conversion device according to the present disclosure, R¹⁺ is preferably at least one of a phenyl group or a chloro group.

In the photoelectric conversion device according to the present disclosure, the photoactive layer preferably includes a compound compound represented by the following Formula (2) as an additive.

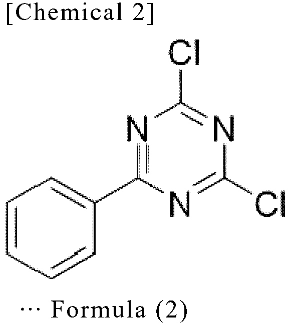

A method for manufacturing a photoelectric conversion device according to the present disclosure is a method for manufacturing a photoelectric conversion device including first and second electrode layers and a photoactive layer that is positioned between the first electrode layer and the second electrode layer. The method for manufacturing the photoelectric conversion device according to the present disclosure includes: a process of preparing a substrate including the first electrode layer; a process of applying a precursor solution containing a perovskite compound and a compound represented by the following Formula (1) as a solute; a process of forming the photoactive layer by volatilizing a solvent of the precursor solution; and a process of forming the second electrode layer, 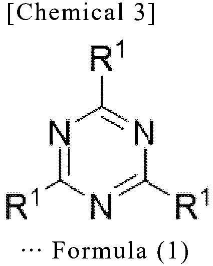 where
R¹ is a monovalent organic group or halogen having carbon atoms of 6 or less, and
a plurality of R¹ may be different from each other.

In the method for manufacturing the photoelectric conversion device according to the present disclosure, the compound represented by the Formula (1) is preferably added to a perovskite compound at a percentage of 0.5 mol % or more but 1.0 mol % or less.

According to the present disclosure, it is possible to provide a photoelectric conversion device and a method for manufacturing a photoelectric conversion device capable of improving durability.

The above and other objects, features and advantages of the present disclosure will become more fully understood from the detailed description given hereinbelow and the accompanying drawings.

### BRIEF DESCRIPTION OF DRAWINGS

Fig. 1 is a cross-sectional view showing a configuration of a photoelectric conversion device according to a first embodiment;
Fig. 2 is a flowchart showing a method for manufacturing the photoelectric conversion device according to the first embodiment;
Fig. 3 is a flowchart showing the method for manufacturing the photoelectric conversion device according to the first embodiment; and
Fig. 4 is a graph showing results of durability tests of photoelectric conversion devices according to Examples and Comparative Example.

### DESCRIPTION OF EMBODIMENTS

### <First Embodiment>

### (Configuration of Photoelectric Conversion Device)

Hereinafter, with reference to the drawings, a first embodiment according to the present disclosure will be described in detail. First, a configuration of a photoelectric conversion device according to this embodiment will be described in detail.

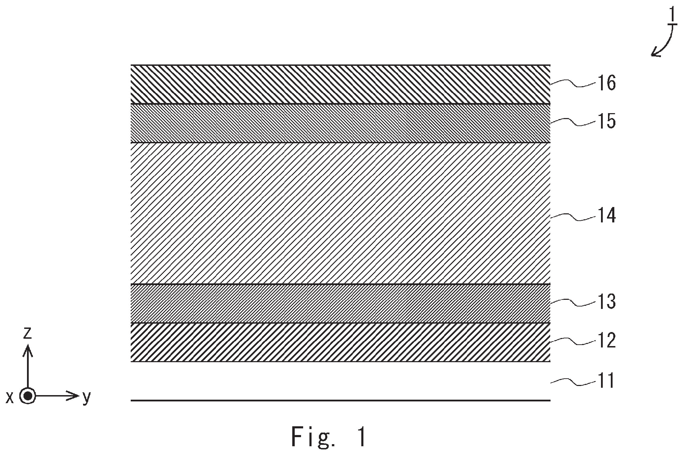

Fig. 1 is a cross-sectional view showing a configuration of the photoelectric conversion device according to the first embodiment. More specifically, Fig. 1 is a schematic cross-sectional view when the photoelectric conversion device according to the first embodiment is cut on a plane perpendicular to the main surface. As a matter of course, the right-handed xyz orthogonal coordinates shown in Fig. 1 and other drawings are for the sake of convenience in explaining the position relationship of the components, which are common throughout the drawings.

Further, the z-axis positive side may be herein expressed as an upper side and the z-axis negative side may be herein expressed as a lower side for the sake of convenience.

A photoelectric conversion device 1 according to this embodiment is a device that converts light incident from the z-axis positive side or the z-axis negative side into electric power. The photoelectric conversion device 1 is typically used as a solar cell.

For example, the photoelectric conversion device 1 according to this embodiment may be used as an upper cell of a tandem solar cell device. Further, the photoelectric conversion device 1 according to this embodiment may be used, for example, for solar cells provided in a window glass of a vehicle or a building.

As shown in Fig. 1, the photoelectric conversion device 1 according to this embodiment includes a substrate 11, a first electrode layer 12, a first carrier transport layer 13, a photoactive layer 14, a second carrier transport layer 15, and a second electrode layer 16.

### (Configuration of Substrate 11)

The substrate 11, which is a plate-like or film-like member, is in contact with the first electrode layer 12 on the main surface on the z-axis positive side of the substrate 11.

The substrate 11 may be made of any material as long as the material transmits at least light having a wavelength band absorbed by the photoelectric conversion device 1. Specific examples of the material of the substrate 11 may include, for example, glass, resin, or the like.

From the viewpoint of manufacturing efficiency, the substrate 11 is preferably a film-like member made of a resin material. From the viewpoint of durability, the substrate 11 is preferably a plate-like member made of a glass material. The configuration of the substrate 11 can be selected as appropriate depending on the purpose and the like of using the photoelectric conversion device 1.

### (Configuration of First Electrode Layer 12)

The first electrode layer 12 is a layer having conductivity and light transmission properties. That is, the first electrode layer 12 is implemented as a transparent electrode layer.

The first electrode layer 12 is in contact with the substrate 11 on the main surface on the z-axis negative side of the first electrode layer 12, and is in contact with the first carrier transport layer 13 on the main surface on the z-axis positive side of the first electrode layer 12. That is, the first electrode layer 12 according to this embodiment is positioned between the substrate 11 and the first carrier transport layer 13.

The first electrode layer 12 receives carriers generated in the photoactive layer 14 via the first carrier transport layer and outputs the received carriers to the outside. The carriers here means holes or conduction electrons.

When the first carrier transport layer 13 that will be described later is a hole transport layer, the first electrode layer 12 receives the holes generated in the photoactive layer 14 as carriers and outputs the received holes to the outside.

Further, when the first carrier transport layer 13 is an electron transport layer, the first electrode layer 12 receives the conduction electrons generated in the photoactive layer 14 as carriers, and outputs the received conduction electrons to the outside.

The material of the first electrode layer 12 may include, for example, Indium Tin Oxide (ITO), Indium Zinc Oxide (IZO), impurity-doped Zinc Oxide (ZnO), F-doped Tin Oxide (FTO), Antimony-doped Tin Oxide (ATO), graphene, and metal nanowires.

### (Configurations of First Carrier Transport Layer 13 and Second Carrier Transport Layer 15)

In the photoelectric conversion device 1 according to this embodiment, the first carrier transport layer 13 is a hole transport layer (HTL) and the second carrier transport layer 15 is an electron transport layer (ETL). That is, the photoelectric conversion device 1 according to this embodiment has an inverted structure.

However, the photoelectric conversion device according to the present disclosure may have a regular structure. That is, the photoelectric conversion device according to the present disclosure may include an electron transport layer (ETL) as the first carrier transport layer and a hole transport layer (HTL) as the second carrier transport layer.

### (Configuration of First Carrier Transport Layer 13)

As described above, the first carrier transport layer 13 according to this embodiment is a hole transport layer (HTL). The first carrier transport layer 13 is in contact with the first electrode layer 12 on the main surface on the z-axis negative side of the first carrier transport layer 13, and is in contact with the photoactive layer 14 on the main surface on the z-axis positive side of the first carrier transport layer 13. That is, the first carrier transport layer 13 according to this embodiment is positioned between the first electrode layer 12 and the photoactive layer 14.

The first carrier transport layer 13 transports holes generated in the photoactive layer 14 to the first electrode layer 12. In other words, the holes generated in the photoactive layer 14 move to the first electrode layer 12 via the first carrier transport layer 13.

As the material of the first carrier transport layer 13, both an inorganic material and an organic material can be used.

Examples of the inorganic hole transport material may include, for example, CuI, CuInSe₂, CuS, CuSCN, GaP, NiO, FeO, Bi₂O₃, MoO₃, and Cr₂O.

Examples of the organic hole transport material may include, for example, polythiophene derivatives, fluorene derivatives, carbazole derivatives, triphenylamine derivatives, diphenylamine derivatives, polysilane derivatives, and polyaniline derivatives.

Specific examples of the polythiophene derivatives include poly-3-hexylthiophene (P3HT) and polyethylene dioxythiophene (PEDOT). Specific examples of the fluorene derivatives include 2,2',7,7'-Tetrakis-(N,N-di-p-methoxyphenylamino)-9,9'-spirobifluorene (Spiro-OMeTAD). Specific examples of the carbazole derivatives include polyvinylcarbazole. Specific examples of the triphenylamine derivatives include poly[bis(4-phenyl)(2,4,6-trimethylphenyl)amine] (PTAA).

### (Configuration of Photoactive Layer 14)

The photoactive layer 14 excites electrons by absorbing solar light that is incident from the z-axis negative side to generate holes and conduction electrons.

The holes generated in the photoactive layer 14 are transported to the first electrode layer 12 via the first carrier transport layer 13, and the conduction electrons generated in the photoactive layer 14 are transported to the second electrode layer 16 via the second carrier transport layer 15.

The photoactive layer 14 according to this embodiment may contain a perovskite compound as a main component, and may contain additives or the like as appropriate. Note that the perovskite compound here indicates a compound group having a perovskite-type crystal structure.

The compound that can be used as the main component of the photoactive layer 14 may include, for example, a perovskite compound expressed by a composition formula shown in the following Formula (3).

AMX₃··· Formula (3)

where
A is a monovalent cation,
M is a divalent cation, and
X is a monovalent anion.

Specific examples of A may include, for example, alkylamine compound ions such as a methylammonium (MA) cation, an ethylammonium cation, and a formamidinium (FA) cation, or alkali-metal ions such as a potassium cation, a cesium cation, and a rubidium cation.

Note that the perovskite compound according to this embodiment may include a plurality of chemical species as A. From the viewpoint of photoelectric conversion efficiency and durability, the perovskite compound preferably includes a cesium cation, a methylammonium cation, and a formamidinium cation.

Specific examples of M may include, for example, a divalent metal ion such as lead, tin, antimony, indium, copper, bismuth, or germanium.

Note that the perovskite compound according to this embodiment may include a plurality of chemical species as M. From the viewpoint of photoelectric conversion efficiency and durability, the perovskite compound preferably includes at least one of a lead cation and a tin cation.

Specific examples of X may include, for example, halide ions such as fluorine, chlorine, bromine, and iodine.

Note that the perovskite compound according to this embodiment may include a plurality of chemical species as X. From the viewpoint of photoelectric conversion efficiency and durability, the perovskite compound preferably includes at least one of bromine and iodine.

The chemical species used as A, M, and X and its compositions can be adjusted as appropriate in accordance with the performance requested for the photoelectric conversion device. In other words, the photoelectric conversion device 1 according to this embodiment can adjust, for example, performance such as durability and absorption wavelength by adjusting the chemical species used as A, M, and X and its compositions.

Here, the photoactive layer 14 according to this embodiment contains the compound represented by the following Formula (1) as an additive. As the compound represented by the following Formula (1) is contained as an additive, the photoelectric conversion device 1 according to this embodiment can improve durability. 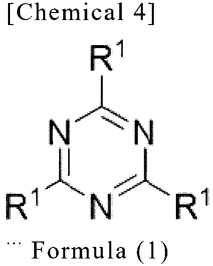 where
R¹ is a monovalent organic group or halogen having carbon atoms of 6 or less, and
a plurality of R¹ may be different from each other.

When R¹ is halogen, specific examples of R¹ include a fluoro group, a chloro group, a bromo group, and an iodine group.

When R¹ is a monovalent organic group having carbon atoms of 6 or less, specific examples of R¹ include an aryl group such as a phenyl group and a pyridyl group, a linear alkyl group such as a hexyl group, a pentyl group, a butyl group, a propyl group, an ethyl group, and a methyl group, an alkyl group having a branched structure such as an isobutyl group and an isopropyl group, and an alkyl group having a ring structure such as a cyclohexyl group.

From the viewpoint of durability, R¹⁺ is preferably at least one of a phenyl group or a chloro group. From the viewpoint of improving durability, the compound represented by the above Formula (1) is particularly preferably 2,4-Dichloro-6-phenyl-1,3,5-triazine represented by the following Formula (2).

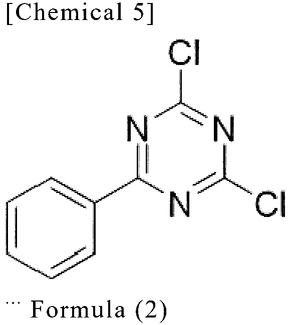

### (Configuration of Second Carrier Transport Layer 15)

As described above, the second carrier transport layer 15 according to this embodiment is an electron transport layer (ETL). The second carrier transport layer 15 is in contact with the photoactive layer 14 on the main surface on the z-axis negative side of the second carrier transport layer 15, and is in contact with the second electrode layer 16 on the main surface on the z-axis positive side of the second carrier transport layer 15. That is, the second carrier transport layer 15 according to this embodiment is positioned between the photoactive layer 14 and the second electrode layer 16.

The second carrier transport layer 15 transports conduction electrons generated in the photoactive layer 14 to the second electrode layer 16. In other words, the conduction electrons generated in the photoactive layer 14 are transported to the second electrode layer 16 via the second carrier transport layer 15.

Examples of the compound that can be used as a main component of the second carrier transport layer 15 include single-electron transport materials, oxide electron transport materials, sulfide electron transport materials, and organic electron transport materials.

Specific examples of the single-electron transport materials may include, for example, silicon or germanium. Specific examples of the oxide electron transport materials may include, for example, oxides of titanium, tin, zinc, iron, tungsten, zirconium, hafnium, strontium, indium, cerium, yttrium, lanthanum, vanadium, niobium, and tantalum. Specific examples of the sulfide electron transport materials may include, for example, sulfides of cadmium, zinc, lead, silver, antimony, and bismuth. Specific examples of the organic electron transport materials may include, for example, fullerene derivatives such as fullerene C₆₀ or Phenyl-C₆₁-Butyric acid Methyl ester (PCBM, [6,6]-Phenyl-C₆₁-Butyric acid Methyl ester).

### (Configuration of Second Electrode Layer 16)

The second electrode layer 16 is a conductive layer. The second electrode layer 16 is in contact with the second carrier transport layer 15 on the main surface on the z-axis negative side of the second electrode layer 16.

The second electrode layer 16 receives carriers generated in the photoactive layer 14 via the second carrier transport layer 15, and outputs the received carriers to the outside.

When the aforementioned second carrier transport layer 15 is an electron transport layer, the second electrode layer 16 receives conduction electrons generated in the photoactive layer 14 as carriers and outputs the received conduction electrons to the outside.

Further, when the second carrier transport layer 15 is a hole transport layer, the second electrode layer 16 receives the holes generated in the photoactive layer 14 as carriers and outputs the received holes to the outside.

The second electrode layer 16 may be an electrode layer having light transmission properties, or may be an electrode layer that does not have light transmission properties. That is, the second electrode layer 16 may be a transparent electrode layer or may not be a transparent electrode layer. In other words, the photoelectric conversion device 1 according to this embodiment may be a transparent photoelectric conversion device or may be a non-transparent photoelectric conversion device.

As described above, the photoelectric conversion device 1 according to this embodiment may be used as an upper cell of a tandem solar cell or used as a photoelectric conversion device of a solar cell used as a window glass. In these cases, the photoelectric conversion device 1 is transparent. That is, in the above cases, the second electrode layer 16 is implemented as a transparent electrode layer.

When the second electrode layer 16 is a transparent electrode layer, the material of the second electrode layer 16 may include, for example, Indium Tin Oxide (ITO), Indium Zinc Oxide (IZO), impurity-doped Zinc Oxide (ZnO), F-doped Tin Oxide (FTO), Antimony-doped Tin Oxide (ATO), graphene, and metal nanowires.

Note that the first electrode layer 12 and the second electrode layer 16 may be made of the same material or may be made of materials different from each other.

When the second electrode layer 16 is not a transparent electrode layer, examples of the material of the second electrode layer 16 may include, for example, metal such as gold, silver, copper, aluminum, tungsten, titanium, chromium, nickel, and cobalt.

### (Method for manufacturing Photoelectric Conversion Device)

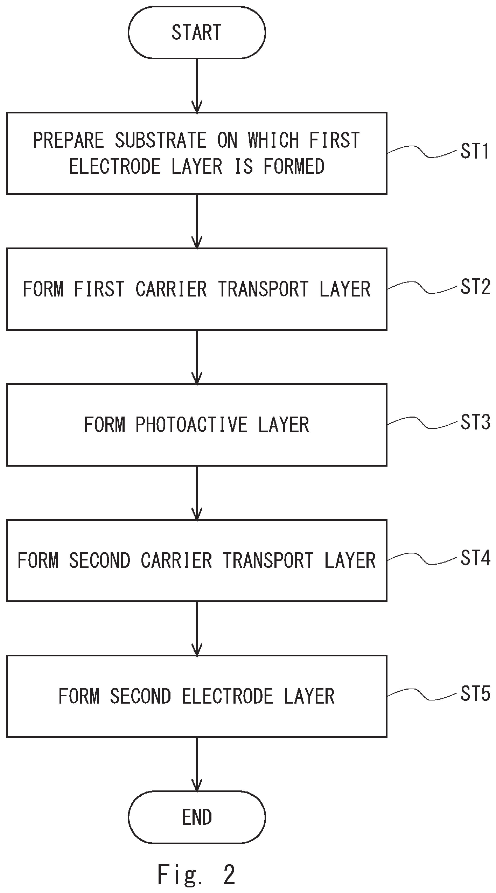

Next, a method for manufacturing a photoelectric conversion device according to this embodiment will be described in detail. Fig. 2 is a flowchart showing the method for manufacturing the photoelectric conversion device according to the first embodiment.

In the method for manufacturing the photoelectric conversion device according to this embodiment, first, a substrate on which a first electrode layer is formed is prepared (Step ST1).

Note that Step ST1 may be a process of forming the first electrode layer 12 on the substrate 11, or may be a process of preparing a commercially-available transparent electrode substrate.

In the method for manufacturing the photoelectric conversion device according to this embodiment, next, a first carrier transport layer 13 is formed (Step ST2). More specifically, in Step ST2, the first carrier transport layer 13 is formed on the first electrode layer 12.

The method for forming the first carrier transport layer 13 may include a method in which a solution in which the material of the first carrier transport layer 13 is dissolved is applied and then a solvent is volatilized, a method for vacuum-depositing the material of the first carrier transport layer 13, or the like. The method for forming the first carrier transport layer 13 can be selected as appropriate depending on the material of the first carrier transport layer 13.

Note that the method for applying the solution may include, for example, an inkjet method, a spray coating method, a die coating method, and a spin coating method.

In the method for manufacturing the photoelectric conversion device according to this embodiment, next, a photoactive layer 14 is formed (Step ST3). More specifically, in Step ST3, the photoactive layer 14 is formed on the first carrier transport layer 13.

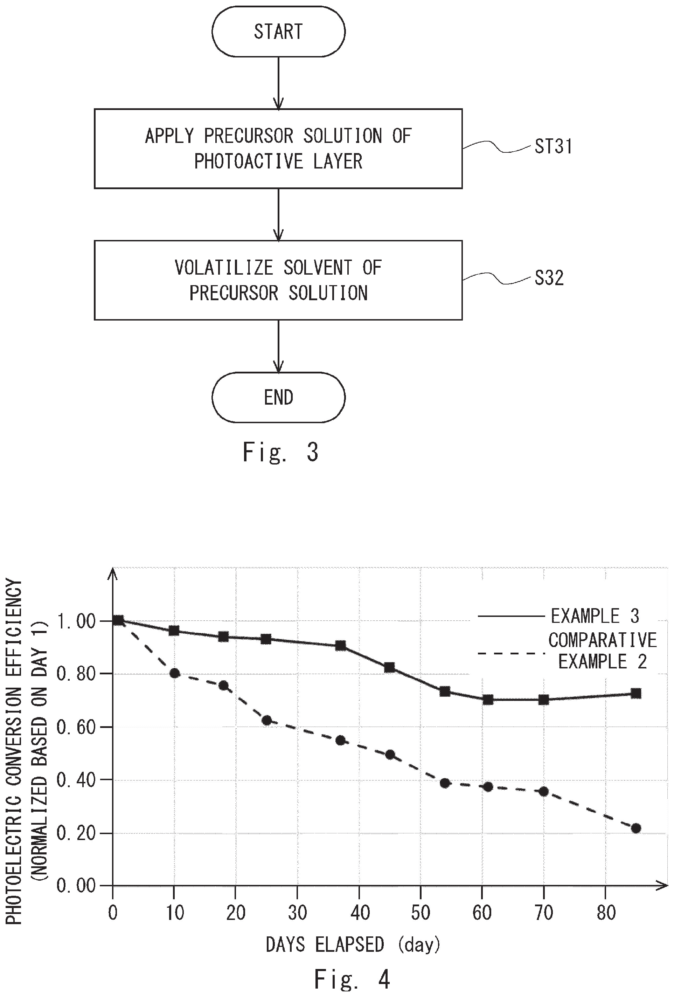

Fig. 3 is a flowchart showing a method for manufacturing the photoelectric conversion device according to the first embodiment. More specifically, Fig. 3 is a flowchart showing the process of Step ST3 in Fig. 2 in more detail.

In Step ST3, first, a precursor solution of the photoactive layer 14 is applied (Step ST31). More specifically, in Step ST31, a precursor solution of the photoactive layer 14 is applied onto the first carrier transport layer 13.

Note that the method for applying the solution may include, for example, an inkjet method, a spray coating method, a die coating method, and a spin coating method.

The precursor solution of the photoactive layer 14 here is a solution that contains a perovskite compound and the compound represented by the above Formula (1) as a solute.

Typically, the precursor solution can be prepared by dissolving the raw materials of the perovskite compound and the compound represented by the above Formula (1).

Specific examples of the solvent of the precursor solution include dimethyl sulfoxide (DMSO), dimethylformamide (DMF), and the mixed solvent thereof.

From the viewpoint of improving durability, the compound represented by the above Formula (1) is preferably added to the perovskite compound at a percentage of 0.5 mol % or more but 1.0 mol % or less.

The raw materials of the perovskite compound includes, for example, the compounds represented by the following Formulas (4) and (5):

AX··· Formula (4)

MX₂··· Formula (5)

where A, M, and X are similar to those in the above Formula (1).

When the perovskite compound includes a plurality of types of monovalent cation, that is, chemical species represented by A in the above Formulas (3) and (4), the precursor solution may be prepared by using a plurality of types of compounds represented by the above Formula (4).

When, for example, the composition of the perovskite compound is represented by the following Formula (6), compounds represented by the following Formulas (7), (8), (9), and (10) are dissolved into a solvent at a ratio of a:b:c:1, whereby a precursor solution can be prepared.

CsₐMA_{b}FA_{c}PbI₃··· Formula (6)

CsI··· Formula (7)

MAI··· Formula (8)

FAI··· Formula (9)

PbI₂··· Formula (10)

where
MA is a methylammonium cation,
FA is a formamidinium cation,
a, b, c are positive real numbers, and $a + b + c = 1 .$

Next, a solvent of the precursor solution of the photoactive layer 14 is volatilized (Step ST32), whereby formation of the photoactive layer 14 is completed. That is, as a result of execution of Step ST32, Step ST3 is completed.

In the method for manufacturing the photoelectric conversion device according to this embodiment, next, the second carrier transport layer 15 is formed (Step ST4). More specifically, in Step ST4, the second carrier transport layer 15 is formed on the photoactive layer 14.

The method for forming the second carrier transport layer 15 may include a method in which a solution in which the material of the second carrier transport layer 15 is dissolved is applied and then a solvent is volatilized, a method for vacuum-depositing the material of the second carrier transport layer 15, or the like. The method for forming the second carrier transport layer 15 can be selected as appropriate depending on the material of the second carrier transport layer 15.

Note that the method for applying the solution may include, for example, an inkjet method, a spray coating method, a die coating method, and a spin coating method.

In the method for manufacturing the photoelectric conversion device according to this embodiment, last, the second electrode layer is formed (Step ST5), whereby the photoelectric conversion device 1 is completed. More specifically, in Step ST5, the second electrode layer 16 is formed on the second carrier transport layer 15. As a result of execution of Step ST5, the state of the photoelectric conversion device according to this embodiment is as shown in Fig. 1.

The method for forming the second electrode layer 16 may include a method in which a solution in which the material of the second electrode layer 16 is dissolved is applied and then a solvent is volatilized, a method for vacuum-depositing the material of the second electrode layer 16, or the like. The method for forming the second electrode layer 16 can be selected as appropriate depending on the material of the second electrode layer 16.

Note that the method for applying the solution may include, for example, an inkjet method, a spray coating method, a die coating method, and a spin coating method.

### EXAMPLES

Hereinafter, the present disclosure will be described in further detail with reference to Examples. The present disclosure is not limited to the following Examples.

### <Preparation of Photoactive Layer>

### (Example 1)

Cesium iodide (CsI), methylammonium iodide (MAI), formamidinium iodide (FAI), and lead iodide (PbI₂) were dissolved into a mixed solvent of N,N-dimethylformamide (DMF) and dimethyl sulfoxide (DMSO) in such a way that the concentration of the perovskite compound becomes 1.0 M. After that, 0.5 mol % of 2,4-Dichloro-6-phenyl-1,3,5-triazine was added to the perovskite compound to thereby prepare a precursor solution of a photoactive layer.

Chlorobenzene was added to an FTO glass substrate while spin coating the prepared precursor solution. After that, the substrate was baked for one hour on a 100°C hot plate to thereby prepare a photoactive layer.

### (Example 2)

A photoactive layer was manufactured in a way similar to that in Example 1 except that 1.0 mol % of 2,4-Dichloro-6-phenyl-1,3,5-triazine was added to a perovskite compound.

### (Comparative Example 1)

A photoactive layer was manufactured in a way similar to that in Example 1 except that 2,4-Dichloro-6-phenyl-1,3,5-triazine was not added.

### <Preparation of Photoelectric Conversion Device>

### (Example 3)

First, an isopropanol solution of titanium oxide (0.15 M) was spin-coated onto an FTO glass substrate. After that, the FTO glass substrate was heated at 120°C for 5 minutes to form an electron transport layer.

Next, Cesium iodide (CsI), methylammonium iodide (MAI), formamidinium iodide (FAI), and lead iodide (PbI₂) were dissolved into a mixed solvent of N,N-dimethylformamide (DMF) and dimethyl sulfoxide (DMSO) in such a way that the concentration of the perovskite compound becomes 1.0 M. After that, 0.5 mol % of 2,4-Dichloro-6-phenyl-1,3,5-triazine was added to the perovskite compound to thereby prepare a precursor solution of a photoactive layer.

Chlorobenzene was added to an FTO glass substrate while spin coating the prepared precursor solution. After that, the FTO glass substrate was heated for one hour on a 100°C hot plate to thereby prepare a photoactive layer.

Next, 72.3 mg of Spiro-OMeTAD, 9.1 mg of Lithium Bis(trifluoromethanesulfonyl)imide, 8.7 mg of FK209 Co(III)TFSI, and 28.8 µL of 4-tert-Butylpyridine were dissolved into 1 mL of chlorobenzene to prepare a solution. The prepared solution was spin-coated onto a photoactive layer, and then left still for 10 minutes at a room temperature, to thereby form a hole transport layer.

Lastly, a gold electrode was deposited on the hole transport layer, to thereby form a back electrode.

### (Comparative Example 2)

A photoelectric conversion device was manufactured in a way similar to that in Example 3 except that 2,4-Dichloro-6-phenyl-1,3,5-triazine was not added.

### <Measurement of Cumulative Absorbance of Photoactive Layer>

The cumulative absorbance at 450 nm-800 nm was measured by using the UV-visible spectroscopy system (model number: Cary 8454) manufactured by Agilent Technologies. Table 1 shows the results.

### <Measurement by X-ray Diffraction Method of Photoactive Layer>

A half-value width of the peak (about 14 degrees) corresponding to the (1,1,0) plane of a perovskite crystal was measured by using the X-ray diffractometer (SMARTLAB) manufactured by Rigaku Holdings Corporation. Table 1 shows the results.

### <Measurement of Average Particle Diameter of Photoactive Layer>

Images of perovskite crystals were captured by using the scanning electron microscope (model number: JSM-7610F) manufactured by JEOL Ltd. Then, the average particle diameter of the perovskite crystals were measured based on the captured images. Table 1 shows the results.

**[Table 1]**

| | **Additive** | | **Cumulative Absorbance (450-800 nm)** | **Half-value Width (XRD peak)** | **Average Particle Diameter (nm)** |
|---|---|---|---|---|---|
| | **Structural Formula** | **Percentage** | | | |
| **Example 1** | 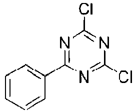 | **0.5mol%** | **236.85** | **0.40998** | **256** |
| **Example 2** | | **1.0mol%** | **232.13** | **0.39686** | **286** |
| **Comparative Example 1** | **No** | **No** | **230.63** | **0.41691** | **214** |

### <Durability Test of Photoelectric Conversion Device>

A prepared photoelectric conversion device was left still for 70 days in an environment with a room temperature and 43% humidity, and photoelectric conversion efficiency, a short-circuit current, an open-circuit voltage, and a fill factor were measured as appropriate. Table 2 shows the results of the photoelectric conversion device according to Example 3, and Table 3 shows the results of the photoelectric conversion device according to Comparative Example 3. Further, Fig. 4 shows the results of Tables 2 and 3 in a graph.

Note that the photoelectric conversion efficiency, the short-circuit current, the open-circuit voltage, and the fill factor shown in each of Tables 2 and 3 are normalized based on the photoelectric conversion efficiency, the short-circuit current, the open-circuit voltage, and the fill factor on Day 0, which is the date on which the photoelectric conversion device was prepared.

**[Table 2]**

| (Example 3) | | | | |
|---|---|---|---|---|
| Days Elapsed | Photoelectric Conversion Efficiency (normalized based on Day 1) | Short-circuit Current (normalized based on Day 1) | Open-circuit Voltage (normalized based on Day 1) | Fill Factor (normalized based on Day 1) |
| 1 | 1.00 | 1.00 | 1.00 | 1.00 |
| 10 | 0.96 | 0.96 | 0.97 | 1.00 |
| 18 | 0.94 | 0.96 | 0.97 | 1.01 |
| 25 | 0.93 | 0.94 | 0.97 | 1.01 |
| 37 | 0.91 | 0.92 | 0.97 | 1.01 |
| 45 | 0.82 | 0.88 | 0.94 | 0.98 |
| 54 | 0.73 | 0.88 | 0.92 | 0.90 |
| 61 | 0.70 | 0.84 | 0.92 | 0.90 |
| 70 | 0.70 | 0.81 | 0.92 | 0.93 |
| 85 | 0.72 | 0.83 | 0.93 | 0.93 |

**[Table 3]**

| (Comparative Example 2) | | | | |
|---|---|---|---|---|
| Days Elapsed | Photoelectric Conversion Efficiency (normalized based on Day 1) | Short-circuit Current (normalized based on Day 1) | Open-circuit Voltage (normalized based on Day 1) | Fill Factor (normalized based on Day 1) |
| 1 | 1.00 | 1.00 | 1.00 | 1.00 |
| 10 | 0.80 | 0.87 | 1.05 | 0.88 |
| 18 | 0.76 | 0.87 | 1.07 | 0.82 |
| 25 | 0.63 | 0.86 | 0.97 | 0.75 |
| 37 | 0.55 | 0.78 | 0.93 | 0.75 |
| 45 | 0.49 | 0.68 | 1.00 | 0.72 |
| 54 | 0.39 | 0.68 | 0.93 | 0.62 |
| 61 | 0.38 | 0.64 | 0.97 | 0.61 |
| 70 | 0.36 | 0.56 | 0.95 | 0.67 |
| 85 | 0.22 | 0.58 | 0.91 | 0.42 |

### <Regarding Results of measuring Cumulative Absorbance of Photoactive Layer>

It has become clear, from the comparison between Examples 1 and 2 and Comparative Example 1, that cumulative absorbance is improved by adding the compound represented by the above Formula (1).

Further, it has become clear, from the comparison among Example 1, Example 2, and Comparative Examples, that it is preferable to add the compound represented by the above Formula (1) to the perovskite compound at a percentage of 0.5 mol % or more but 1.0 mol % or less from the viewpoint of improving cumulative absorbance.

### <Regarding Results of measurement by X-ray Diffraction Method of Photoactive Layer>

It has become clear, from the comparison between Examples 1 and 2 and Comparative Example 1, that a half-value width of the peak (14 degrees) corresponding to the (1,1,0) plane of the perovskite crystal is suppressed by adding the compound represented by the above Formula (1). That is, it has become clear that the crystallinity of the perovskite crystals is improved by adding the compound represented by the above Formula (1).

It has also become clear, from the comparison between Example 1 and Example 2, that it is preferable to add the compound represented by the above Formula (1) to the perovskite compound at a percentage of 1.0 mol % or more from the viewpoint of improving crystallinity.

### <Regarding Results of measuring Average Particle Diameter of Photoactive Layer>

It has become clear, from the comparison between Examples 1 and 2 and Comparative Example 1, that the average particle diameter is improved by adding the compound represented by the above Formula (1).

Further, it has become clear, from the comparison among Example 1, Example 2, and Comparative Examples, that it is preferable to add the compound represented by the above Formula (1) to the perovskite compound at a percentage of 1.0 mol % or more from the viewpoint of improving the average particle diameter.

### <Regarding Results of Durability Test of Photoelectric Conversion Device>

It has become clear, from the comparison between Example 3 and Comparative Example 2, that the durability of the photoelectric conversion device is improved by adding the compound represented by the above Formula (1).

While the present disclosure has been described in view of the aforementioned embodiment, the present disclosure is not limited to the configurations of the above embodiment. As a matter of course, the present disclosure includes various variations, modifications, and combinations that may be made by one skilled in the art within the scope of the disclosure set forth in the claims of the present application.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A photoelectric conversion device comprising first and second electrode layers (12, 16) and a photoactive layer (14) that is positioned between the first electrode layer (12) and the second electrode layer (16),
wherein the photoactive layer (14) contains a perovskite compound as a main component and contains a compound represented by the following Formula (1) as an additive: 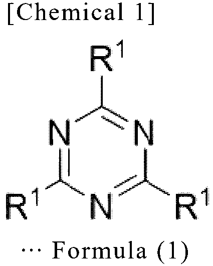 where
R¹ is a monovalent organic group or halogen having carbon atoms of 6 or less, and
a plurality of R¹ may be different from each other.

2. The photoelectric conversion device according to claim 1, wherein the R¹⁺ is at least one of a phenyl group or a chloro group.

3. The photoelectric conversion device according to claim 2, wherein the photoactive layer (14) contains a compound represented by the following Formula (2) as an additive.

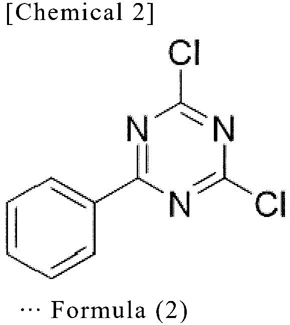

4. A method for manufacturing a photoelectric conversion device comprising first and second electrode layers (12, 16) and a photoactive layer (14) that is positioned between the first electrode layer (12) and the second electrode layer (16), the method comprising:
a process of preparing a substrate (11) including the first electrode layer (12);
a process of applying a precursor solution containing a perovskite compound and a compound represented by the following Formula (1) as a solute;
a process of forming the photoactive layer (14) by volatilizing a solvent of the precursor solution; and
a process of forming the second electrode layer (16), 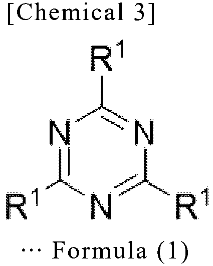 where
R¹ is a monovalent organic group or halogen having carbon atoms of 6 or less, and
a plurality of R¹ may be different from each other.

5. The method for manufacturing the photoelectric conversion device according to claim 4, comprising adding the compound represented by the Formula (1) to a perovskite compound at a percentage of 0.5 mol % or more but 1.0 mol % or less.
